# EUROPÄISCHE PATENTANMELDUNG

(11) **EP 2 809 006 A1**
(43) Veröffentlichungstag der Anmeldung: **03.12.2014**
(21) Anmeldenummer: 14155812.2
(22) Anmeldetag: 19.02.2014
(51) Int. Cl.: H03K 17/96

(54) **Bedienelement**

(30) Priorität: 27.05.2013 DE 102013209849
(71) Anmelder: E.G.O. Elektro-Gerätebau GmbH, 75038 Oberderdingen (DE)
(72) Erfinder: Keller, Hartmut, 76356 Weingarten (DE); Schmid, Dennis, 76703 Kraichtal (DE); Graff, Frank, 16818 Radensieben (DE); Ungethuem, Uwe, 15528 Spreenhagen (DE)
(74) Vertreter: Patentanwälte Ruff, Wilhelm, Beier, Dauster & Partner

(57) **Zusammenfassung**

Ein Bedienelement weist ein Bedienelementgehäuse auf, auf dessen Oberseite eine abstehende Rippe aus elastischem Material angeordnet ist, wobei die Rippe bzw. ihr Querschnitt für eine Formelastizität ausgebildet ist. Dies kann erreicht werden durch einen elastisch abstehenden Abschnitt mit einer Erstreckungsrichtung nach außen weg von der sonstigen Rippe im Wesentlichen schräg zu einer Ebene der Oberseite des Bedienelements.

## Beschreibung

### Anwendungsgebiet und Stand der Technik

Die Erfindung betrifft ein Bedienelement mit einem Bedienelementgehäuse, wobei in dessen oberen Bereich bzw. auf dessen Oberseite mindestens eine Rippe aus elastischem Material angeordnet ist.

Es ist beispielsweise aus der WO 2013/174728 A1 bekannt, ein solches Bedienelement auszubilden für eine Bedieneinrichtung gemäß dem Funktionsprinzip mit kapazitiven Berührungssensoren. An der Oberseite eines Bedienelementgehäuses ist dabei eine nach oben abstehende Rippe aus elastischem und elektrisch leitfähigem Material angeordnet in umlaufender Form. Sie ist unten auf eine Leiterplatte als Träger aufgesetzt und elektrisch damit verbunden und wirkt als kapazitiver Berührungssensor für einen entsprechenden Berührschalter einer Bedieneinrichtung.

### Aufgabe und Lösung

Der Erfindung liegt die Aufgabe zugrunde, ein eingangs genanntes Bedienelement zu schaffen, mit dem Probleme des Standes der Technik gelöst werden können und es insbesondere möglich ist, ein solches Bedienelement praxistauglich und vielseitig verwendbar sowie funktionssicher auszugestalten.

Gelöst wird diese Aufgabe durch ein Bedienelement mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass im oberen Bereich des Bedienelementgehäuses bzw. auf seiner Oberseite mindestens eine Rippe zumindest teilweise entlangläuft. Diese Rippe besteht aus elastischem Material und steht von dem Bedienelementgehäuse ab, vorteilhaft nach oben und besonders vorteilhaft auch seitlich etwas über.

Gemäß einem ersten grundlegenden Aspekt der Erfindung ist im Längsverlauf der Rippe bzw. in der Rippe selbst eine Unterbrechung oder eine Lücke vorgesehen, wodurch die Rippe in mindestens zwei entsprechend abstehende Rippenabschnitte unterteilt werden kann. Die Rippe verläuft somit nicht durchgehend entlang der gesamten Längsseite des Bedienelementgehäuses. Durch die eine Unterbrechung bzw. Lücke oder durch die mehreren Unterbrechungen bzw. Lücken wird zwar keine Änderung der Form bzw. Querschnittsform der Rippe bewirkt. Es kann aber dennoch eine Reduzierung der Andrückkraft insgesamt erreicht werden, mit der das Bedienelement oder ein Bauteilträger mit einer Vielzahl von solchen Bedienelementen darauf an eine Unterseite einer Abdeckung oder einer Bedienblende angedrückt werden muss, weil ja quasi weniger Rippenlänge angedrückt werden muss. Durch die Art bzw. den Umfang der Unterbrechung der Rippe kann diese Andrückkraft beeinflusst werden. Letztlich wird bei diesem Aspekt der Erfindung die notwendige Andrückkraft bestimmt durch das Verhältnis der Gesamtlänge der Rippe bzw. der Rippenabschnitte zu der Gesamtlänge oder Summe der Längen der Unterbrechungen bzw. Lücken. Ob diese dann jeweils in wenige lange oder mehrere kürzere Rippenabschnitte unterteilt sind spielt eine eher untergeordnete Rolle, kann sich aber natürlich produktionstechnisch vereinfachend oder erschwerend auswirken.

Das Bedienelementgehäuse kann allgemein in der Draufsicht eckig ausgebildet sein bzw. viereckig, vorteilhaft ist es rechteckig. Dabei können im Prinzip entlang jeder Seite Rippen bzw. Rippenabschnitte vorgesehen sein, wobei entlang jeder Seite die Rippe in mindestens zwei, unter Umständen auch mehr, Rippenabschnitte unterteilt ist durch die Unterbrechung bzw. Lücken.

Einerseits ist es möglich, dass die Summe der Längen der Unterbrechungen bzw. Lücken entlang einer Seite kleiner ist als die Summe der Längen der einzelnen Rippenabschnitte. Die Gesamtlänge der Unterbrechungen kann beispielsweise 20% bis 60% der Gesamtlänge der Rippenabschnitte betragen, also deutlich kleiner sein. Die Rippenabschnitte verlaufen an einem größeren Prozentsatz einer Längsseite des Bedienelementgehäuses.

Andererseits kann die Summe der Längen der Unterbrechungen bzw. Lücken in der Rippe größer sein als die Summe der Längen der Rippenabschnitte selbst. Vorteilhaft kann sie deutlich größer sein, also beispielsweise 5mal bis 20mal so groß sein wie die Summe der Längen der Rippenabschnitte. Somit verlaufen also nur an einem kleinen Prozentsatz einer Längsseite des Bedienelementgehäuses Rippenabschnitte, beispielsweise 5% bis 20%.

Hier können bei einem in der Draufsicht mehreckigen Bedienelementgehäuse, welches vorteilhaft rechteckig ist, nur sehr kurze Rippenabschnitte vorgesehen sein, die insbesondere in etwa so lang sind wie breit. Sie ähneln also eher einem nach oben ragendem Zylindervorsprung als einer Rippe in dieser Art extremen Ausgestaltung der Erfindung mit sehr großen Unterbrechungen und sehr kurzen Rippenabschnitten. Derart kurze Rippenabschnitte können grundsätzlich an beliebiger Stelle oben am Bedienelementgehäuse vorgesehen sein, vorteilhaft pro Längsseite des Bedienelementgehäuses nur ein einziger. Besonders vorteilhaft können diese Rippenabschnitte nur in Eckbereichen des Bedienelementgehäuses vorgesehen sein bzw. in jedem Eckbereich genau ein solcher Rippenabschnitt oder kleiner Vorsprung. In diesem Fall ist zu vermuten, dass eine Andrückkraft des Bedienelementgehäuses von unten an eine Bedienblende oder Abdeckung sehr gering ist und eine gute Anlage des Bedienelementgehäuses mit allen Rippenabschnitten bzw. Vorsprüngen an der Unterseite möglich ist.

In weiterer Ausgestaltung der Erfindung können die Rippenabschnitte etwa 1mal bis 6mal so lang sein wie breit. So sind es tendenziell längliche Rippenabschnitte. Es ist auch möglich, dass die Rippenabschnitte jeweils eine Länge aufweisen entlang der Seiten des Bedienelementgehäuses, welche zwischen 50% und 200% ihrer Breite beträgt. Dann liegt eher der vorbeschriebene Fall der sehr kurzen Rippenabschnitte bzw. Vorsprünge vor.

Allgemein kann vorgesehen sein, dass die Breite der Rippen zwischen 50% und 150% der Höhe der Rippen entspricht. Beide liegen also in etwa in derselben Größenordnung. Für die Rippen bzw. die Rippenabschnitte kann sich dies auf die Breite der Rippen am Ansatz am Bedienelementgehäuse bzw. an dessen Oberseite beziehen.

Gemäß einem zweiten grundlegenden Aspekt der Erfindung ist die Rippe bzw. ist ein Querschnitt der Rippe, der vorteilhaft über wesentliche Längenbereiche gleich ist, so ausgebildet, dass er nicht nur materialelastisch ist durch die Wahl eines entsprechenden Elastomers, sondern auch formelastisch bzw. er ist für eine Formelastizität ausgebildet. So kann zusätzlich zu möglichen Limitationen aufgrund einer Materialwahl bezüglich Materialbeständigkeit sowie eventuell elektrischer Leitfähigkeit und Temperaturbeständigkeit die gesamte Elastizität der Rippe beeinflusst werden und insbesondere noch erhöht werden. So ist beispielsweise selbst mit relativ harten bzw. wenig elastischen Materialien mit einer hohen Shore-Härte, beispielsweise 50 bis 70 oder sogar 80 Härte Shore A, eine insgesamt sehr elastische Rippe erreichbar, nämlich eben durch die Formelastizität der Rippe selbst bzw. ihres Querschnitts.

Vorteilhaft kann ein elastisch bzw. federelastisch abstehender Abschnitt der Rippe vorgesehen sein, der sich von ihr weg erstreckt in einer Richtung im Wesentlichen schräg zu einer Ebene der Oberseite des Bedienelements. Dann wird eine Elastizität der Rippe nicht nur durch reine Kompressibilität erreicht, sondern durch Verformung bzw. Verbiegung der Rippe bzw. des abstehenden Abschnitts. Ein Andrücken des Bedienelementes, also des Bedienelementgehäuses, an eine Bedienfläche, insbesondere an deren Unterseite, kann dann für eine sichere und ausreichende Anlage der Rippe oder mehrerer Rippen des Bedienelementgehäuses mit geringerer Kraft erfolgen. Somit sind insgesamt geringere Kräfte notwendig bzw. bei einer Bedieneinrichtung mit einer Vielzahl solcher Bedienelemente bzw. Bedienelementgehäuse kann eine Andrückung insgesamt mit geringerer Gesamt-Kraft erfolgen.

In vorteilhafter Ausgestaltung der Erfindung kann ein vorgenannter abstehender Abschnitt der Rippe einen wesentlichen Bereich davon bilden. Vorteilhaft ist dieser abstehende Abschnitt oberhalb des Bedienelementgehäuses angeordnet, wodurch er eben freier bewegbar ist bzw. auch freier abgebogen oder umgebogen werden kann. Ein weiterer Bereich der Rippe kann direkt auf der Oberseite oder an einer Außenseite des Bedienelementgehäuses entlanglaufen zur Befestigung daran, unter Umständen auch darin verlaufen für eine sichere und dauerhafte Befestigung.

In weiterer Ausgestaltung der Erfindung kann vorgesehen sein, dass der abstehende Abschnitt der Rippe von einer Oberseite oder einem oberen Bereich des Bedienelementgehäuses nach außen wegsteht, sich also quasi von einer durch die Rippen eines Bedienelementgehäuses zumindest annähernd definierten Fläche entfernt. So kann beispielsweise eine im Inneren des Bedienelementgehäuses vorgesehene Beleuchtung unbeeinträchtigt bleiben bzw. die wesentliche Fläche der Oberseite des Bedienelementgehäuses zur Verfügung haben.

Ein Winkel, mit dem der Abschnitt bzw. der wesentliche Teil der Rippe seitlich absteht, kann vorteilhaft 30° bis 60° betragen. Besonders vorteilhaft beträgt er zwischen 40° und 50°. Je flacher der Winkel ist, desto leichter lässt sich der abstehende Abschnitt nach unten drücken bzw. desto elastischer ist die Rippe quasi gegen Druckkraft von oben. Gleichzeitig nimmt damit natürlich der zur Verfügung stehende Federweg ab, so dass ein Kompromiss zu finden ist.

In einer grundsätzlichen Ausgestaltung der Erfindung kann die Rippe bzw. ihr Querschnitt massiv ausgebildet sein ohne Hohlräume. Dies gilt insbesondere für den abstehenden Abschnitt bzw. den Bereich der Rippe über dem bzw. außerhalb von dem Bedienelementgehäuse. Dann wird die Elastizität im Wesentlichen durch die schräge Stellung bzw. abstehende Form des abstehenden Abschnitts erreicht. Unter Umständen kann der abstehende Abschnitt, insbesondere auch nahe am Bedienelementgehäuse bzw. in einem Übergang dazu, einen Einschnitt odgl. aufweisen. Dieser kann quasi Scharnierwirkung haben für ein leichteres Abkippen.

In einer alternativen grundsätzlichen Ausgestaltung der Erfindung kann die Rippe bzw. ihr Querschnitt auch dadurch besonders elastisch gemacht werden, dass eine hinterschnittene Öffnung vorgesehen ist oder dass die Rippe ein Hohlprofil ist. So kann eben, selbst mit geringen Hinterschnitten, eine Elastizität nochmals erhöht werden. Durch ein Hohlprofil kann eine relativ große Außenfläche bei geringer Wandstärke und somit geringer Festigkeit erreicht werden. Auch hier wird weitgehend eine Formelastizität erreicht.

In einer nochmals weiteren Ausgestaltung der Erfindung ist die mindestens eine Rippe länglich und im Längsquerschnitt gesehen konvex gebogen weg von der Oberseite des Bedienelementgehäuses. Das bedeutet, dass die Rippe im Längsquerschnitt gesehen zuerst vom Bedienelementgehäuse eher zur Seite weg geht und dann nach oben gebogen ist. Eine Endrichtung der Biegung an einer freien Kante der Rippe, also dem Ende des Längsquerschnitts, kann in einem Winkel von 60° bis 90° zur Oberseite stehen bzw. verlaufen. Durch diese Ausgestaltung der Rippe kann sie bei Andrücken an eine Bedienblende oder Abdeckung darüber noch leichter als nur durch seitliches Abstehen nach unten weggedrückt werden, wodurch die benötigte Andruckkraft bzw. Federkraft nochmals geringer wird.

In Ausgestaltung der Erfindung ist es möglich, dass nur an zwei von vier Längsseiten des Bedienelementgehäuses jeweils eine abstehende Rippe mit einer vorgenannten Biegung im Längsquerschnitt vorgesehen ist. Vorteilhaft sind sie an gegenüberliegenden Längsseiten vorgesehen, besonders vorteilhaft an gegenüberliegenden kürzeren Längsseiten. An den anderen Längsseiten können dann entweder normal durchgehende Rippen bzw. Rippenabschnitte vorgesehen sein oder die zuvor genannten mehreren Rippenabschnitten mit Unterbrechungen entlang einer Längsseite. Des Weiteren ist es sogar möglich, dass an einer Längsseite mit einer solchen im Längsquerschnitt gesehen gebogenen Rippe, die seitlich vom Bedienelementgehäuse etwas absteht, oben auf dem Bedienelementgehäuse nach oben stehende Rippen bzw. Rippenabschnitte vorgesehen sein können.

In anderer Ausgestaltung der Erfindung ist es möglich, dass die Rippe zwar auch länglich ist, aber in ihrem Längsverlauf gebogen ist, unabhängig davon, wie ihr Längsquerschnitt ist. Diese Biegung der Rippe im Längsverlauf beginnt an einem Rippenansatz am Bedienelementgehäuse, so dass die Rippe zuerst schräg nach oben verläuft bzw. in eine Richtung nach oben zur Bedienblende. Dabei läuft sie über die Oberseite des Bedienelementgehäuses hinaus mit zunehmend flacher werdendem Biegungswinkel. Dann erreicht die Rippe einen Höhepunkt und überschreitet diesen in ihrem Längsverlauf, wobei sie dann wieder nach unten gebogen ist. Vorteilhaft ist die Biegung in etwa symmetrisch im aufsteigenden und im absteigenden Bereich. Am anderen Ende kann die Rippe entweder wieder mit dem Bedienelementgehäuse verbunden sein, insbesondere an einer Ecke des Bedienelementgehäuses oder einem Eckbereich. Alternativ kann das andere Ende der Rippe ein freies Ende sein ohne Befestigung am Bedienelementgehäuse. Auch durch eine derartige Biegung der Rippe, nämlich eben im Längsverlauf, kann eine Andrückkraft stark reduziert werden. Dies liegt vor allem daran, dass bei einigermaßen flachen Biegungen die Rippe nur sehr wenig verbogen bzw. nach unten gedrückt werden muss pro Längeneinheit im Verhältnis zur Strecke, um die sie insgesamt nach unten gebogen werden muss.

Während bei den vorbeschriebenen Ausgestaltungen darauf abgestellt wird, dass eine Rippe entlang einer Längsseite des Bedienelementgehäuses verläuft und zumindest in den Eckbereichen mit dem Bedienelementgehäuse verbunden ist oder daran befestigt ist, kann in weiterer Ausgestaltung der Erfindung vorgesehen sein, dass eine Rippe in ihrem Längsverlauf in Draufsicht auf das Bedienelementgehäuse bzw. auf dessen Oberseite abweichend von einer Geraden gebogen bzw. U-förmig sein. Dabei ist es also möglich, dass eine Rippe nicht von Ecke zu Ecke verläuft, sondern von einem Punkt an einer Längsseite des Bedienelementgehäuses, der ein Stück von einer Ecke entfernt ist, über diese Ecke und vorteilhaft noch über die nächste Ecke hinaus bis wieder zu einem Punkt, der von einer Ecke etwas hinaus bis in die Längsseite des Bedienelementgehäuses hinein gezogen ist. Vor allem bei einer vorbeschriebenen Ausbildung einer Rippe mit Biegung im Längsverlauf ist dies von Vorteil, da die Rippe in diesem winkligen bzw. U-förmigen Längsverlauf nach oben gebogen sein kann. So wird ihre die Biegung aufweisende Länge nochmals vergrößert und eine zum Andrücken notwendige Andrückkraft nochmals verringert. Dabei kann die Rippe an beiden Enden mit dem Bedienelementgehäuse verbunden bzw. daran befestigt sein. Des Weiteren kann vorgesehen sein, dass eine solche winklig verlaufende bzw. U-förmige Rippe innerhalb des Umrisses des Bedienelementgehäuses in der Draufsicht auf die Oberseite verläuft, also nicht seitlich übersteht. Die maximale Höhe der Biegung einer im Längsverlauf gebogenen Rippe über dem Bedienelementgehäuse bzw. über der Oberseite kann wenige Millimeter betragen, vorteilhaft 0,5 mm bis 2 mm oder 3 mm, bzw. etwa 50% bis 200% der Höhe der Rippe selbst betragen.

Vorteilhaft ist das Bedienelementgehäuse im Wesentlichen rechteckig ausgebildet in der Draufsicht, besonders vorteilhaft insgesamt blockartig. An mindestens zwei seiner Seiten sollte eine

Rippe verlaufen, vorteilhaft an benachbarten Seiten. Besonders vorteilhaft verläuft an allen vier Seiten oder Seitenbereichen des Bedienelementgehäuses eine Rippe. Mehrere Rippen sind allgemein vorteilhaft gleichartig ausgebildet bzw. mit gleichem Querschnitt.

Bei der vorbeschriebenen Ausgestaltung von mehreren Rippen entlang der Seitenbereiche des Bedienelementgehäuses sollte in Eckbereichen kein abstehender Abschnitt vorgesehen sein. Durch diese Unterbrechung in den Eckbereichen kann die hohe Elastizität erhalten bleiben. Gleichwohl kann die Rippe vorteilhaft auch über die Eckbereiche verlaufen, insbesondere mit einem flachen Basisbereich, um abstehende Abschnitte an unterschiedlichen Seiten des Bedienelementgehäuses miteinander zu verbinden. So kann eine einteilige Herstellung erreicht werden, die zum einen einfacher ist. Zum anderen kann eine durchgängige elektrische Leitfähigkeit erreicht werden für die vorgenannten Eigenschaften als kapazitives Sensorelement. Derartige durchgehende Verbindungsabschnitte der Rippen können dann als Basis bzw. Basisbereich direkt am Bedienelementgehäuse oder darin verlaufen.

Eine Höhe eines abstehenden Abschnitts kann zwischen 0,5 mm und 3 mm liegen bzw. beispielsweise 5% bis 20% der Höhe des Bedienelementgehäuses betragen. Als vorteilhaft werden allgemein etwa 0,8 bis 1,5 mm Höhe bei einer Höhe des Bedienelementgehäuses zwischen 3 mm und 8 mm angesehen. Eine Dicke eines solchen abstehenden Abschnitts kann etwas unter seiner Höhe liegen, beispielsweise etwa die Hälfte betragen.

Für vorgenannte Eigenschaften der Rippe bzw. der abstehenden Abschnitte als kapazitives Sensorelement sollte dessen elastisches Material elektrisch leitfähig sein. Es kann allgemein ein Elastomer oder ein thermoplastisches Elastomer (TPE) sein, ebenso Gummi bzw. Kautschuk. Es kann elektrisch leitfähig gemacht werden durch Zusätze aus der Gruppe Ruß, Graphit, Metallpulver und/oder Carbon-Nanotubes, vor allem im Fall von TPE. Hier ist eben auf Kosten sowie ausreichende elektrische Leitfähigkeit abzustellen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
Fig. 1 einen seitlichen Schnitt durch ein Bedienelement gemäß einem ersten Aspekt der Erfindung,
Fig. 2 eine Seitenansicht durch einen Einbauzustand des Bedienelements aus Fig. 1 in eine Bedieneinrichtung,
Fig. 3 bis 6 verschiedene Abwandlungen eines Bedienelements der Erfindung ähnlich Fig. 1 mit unterschiedlich ausgebildeten Rippen an der Oberseite und
Fig. 7 bis 15 verschiedene weitere Abwandlungen eines Bedienelements der Erfindung mit unterschiedlich ausgebildeten Rippen an der Oberseite.

### Detaillierte Beschreibung der Ausführungsbeispiele

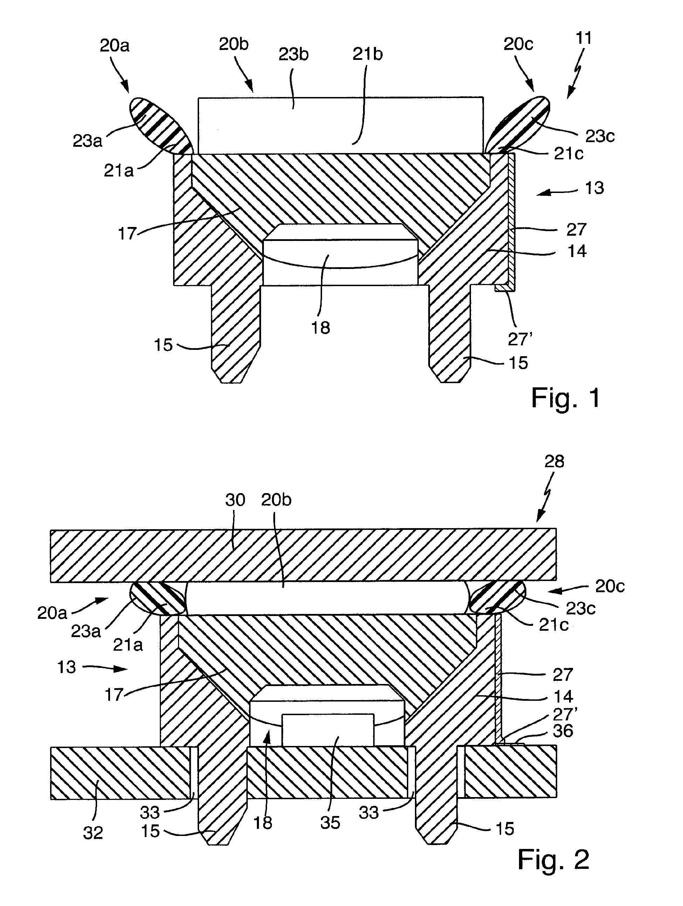

In der Fig. 1 ist ein erfindungsgemäßes Bedienelement 11 dargestellt mit einem Bedienelementgehäuse 13, welches aus einem Mantelkörper 14 mit Haltefüßen 15 an der Unterseite und einem Lichtleiter 17 darin sowie einer mittigen Ausnehmung 18 besteht. Ein solches Bedienelement 11 ist grundsätzlich aus der vorgenannten WO 2013/174728 A1 bekannt, auf welche diesbezüglich ausdrücklich verwiesen wird. Anstelle des Lichtleiters könnte auch nur eine Scheibe oder Folie vorgesehen sein zur Diffusion bzw. Lichtverteilung.

Oben am Bedienelementgehäuse 13 bzw. auf der Oberseite oder an einem Außenrand sind Rippen 20a bis 20c angebracht, vorzugsweise durch Mehrkomponentenspritzen an das Bedienelementgehäuse 13 bzw. den Mantelkörper 14 angespritzt. Während der Mantelkörper 14 aus lichtundurchlässigem Kunststoff und der Lichtleiter 17 aus lichtdurchlässigem Kunststoff besteht, bestehen die Rippen 20a bis 20c aus einem Elastomer, vorteilhaft einem vorgenannten elektrisch leitfähigen Elastomer wie beispielsweise TPE. Die dem Elastomer inhärente Härte kann etwa 10 bis 70 Shore A betragen, vorteilhaft 20 bis 60 Shore A, so dass es relativ weich und elastisch ist.

Der Querschnitt der Rippen 20 ist jeweils identisch. Die Rippe 20a beispielsweise weist einen unteren Basisbereich 21a auf, der direkt an dem Bedienelementgehäuse 13 bzw. dem Mantelkörper 14 angeordnet ist. Der Basisbereich 21a geht über in einen abstehenden Bereich 23a, hier nach Art einer schräg stehenden Lippe odgl.. Der Querschnitt ist bei den Rippen 20a bis 20c über ihre Länge jeweils gleich. Der Basisbereich 21a bis 21c kann auch ein Stück in das Bedienelementgehäuse 13 bzw. Mantelkörper 14 und/oder Lichtleiter 17 hinein versenkt bzw. eingespritzt sein zur besseren Befestigung. Eine weitere vierte Rippe entsprechend der Rippe 21d ist vorgesehen, hier aber nicht dargestellt.

Von der rechten Rippe 20c bzw. vom Basisbereich 21 c verläuft eine stegartige Kontaktierung 27 am Außenbereich des Mantelkörpers 14 nach unten und mündet in einen Kontaktierbereich 27'. Dieser dient zur elektrischen Kontaktierung der Rippen 20a bis 20c, wie nachfolgend noch näher erläutert wird.

Den eingebauten Zustand des Bedienelements 11 zeigt die Fig. 2 mittels einer Bedieneinrichtung 28 samt Bedienfläche 30 in Form einer dünnen und zumindest teilweise lichtdurchlässigen Platte. Das Bedienelement 11 ist an eine Unterseite der Bedienfläche 30 angedrückt mit einer gewissen Kraft. Somit drückt die Bedienfläche 30 die Rippen 20a bis 20c etwas nach unten. Deren Höhe beträgt im Vergleich zu derjenigen aus Fig. 1 nur noch etwa zwei Drittel. Aufgrund der Ausbildung der schräg abstehenden Abschnitte 23a bis 23c erfolgt die Verformung der Rippen 20a bis 20c im Wesentlichen durch Abbiegen der Abschnitte 23a bis 23c nach unten. Bei dem eingangs genannten Stand der Technik in Form der WO 2013/174728 A1 war dies nicht möglich, und die Rippen 20a bis 20c konnten nur elastisch zusammengedrückt werden bzw. komprimiert werden. Es ist offensichtlich, dass die hier durch die abstehenden Abschnitte 23a bis 23c gegebene Form ein Abbiegen bzw. Herunterdrücken nach unten mit erheblich weniger Kraft ermöglicht als ein Komprimieren. Durch den abstehenden Verlauf der abstehenden Abschnitte 23a bis 23c mit einem Winkel von etwa 45°, über ihre gedachte Längsmittelachse gesehen, zur Ebene der Oberseite des Bedienelementgehäuses 13 bzw. des Mantelkörpers 14 sind sie bereits derart schräg voreingestellt, dass sie bei Andrücken an die Unterseite der Bedienfläche 30 leicht noch etwas stärker abgebogen und umgebogen werden können.

Des Weiteren weist die Bedieneinrichtung 28 eine Leiterplatte 32 auf mit Löchern 33, in die die Haltefüße 15 halternd eingesteckt sind. Oben auf der Leiterplatte 32 ist eine LED 35 angeordnet, die in die Ausnehmung 18 ragt und den Lichtleiter 17 durchstrahlt für eine Lichterscheinung, die von oben durch die lichtdurchlässige Bedienfläche 30 hindurch wahrgenommen werden kann. Zur Seite hin wird das Licht abgeschirmt durch den Mantelkörper 14, der fest auf der Oberseite der Leiterplatte 32 aufsitzt, sowie eben die Rippen 20a bis 20c bzw. alle vier umlaufend vorgesehenen Rippen. Hier ist auch zu erkennen, dass der Kontaktfuß 27' der Kontaktierung 27 auf ein Kontaktfeld 36 auf der Leiterplatte 32 aufgedrückt ist zur elektrischen Kontaktierung mittels nicht dargestellter Leiterbahnen an die Rippen 20. Die Rippen 20 bzw. deren an die Unterseite der Bedienfläche 30 angedrückten, länglichen Bereiche bilden ein kapazitives Bedienelement bzw. eine kapazitive Sensorfläche, wie es in der eingangs genannten DE 102012010321 beschrieben ist.

Aus der Darstellung der Fig. 1 und 2 ist auch relativ offensichtlich, warum die Rippen 20a bis 20c in den Eckbereichen des Bedienelementgehäuses 13 nicht durchgängig miteinander verbunden sein sollten, zumindest nicht oben an den abstehenden Abschnitten 23a bis 23c. Ansonsten können sie nur deutlich schlechter um- und nach außen gebogen werden, da dies sonst eine Längung ihrer Umlauflänge bedeuten würde, was bei einer geschlossen umlaufenen Ausbildung nur schwer möglich ist. Dafür können beispielsweise die Basisbereiche 21 a bis 21 c umlaufend ausgebildet sein mit jeweils einzeln aufgesetzten und nach außen abstehenden Abschnitten 23.

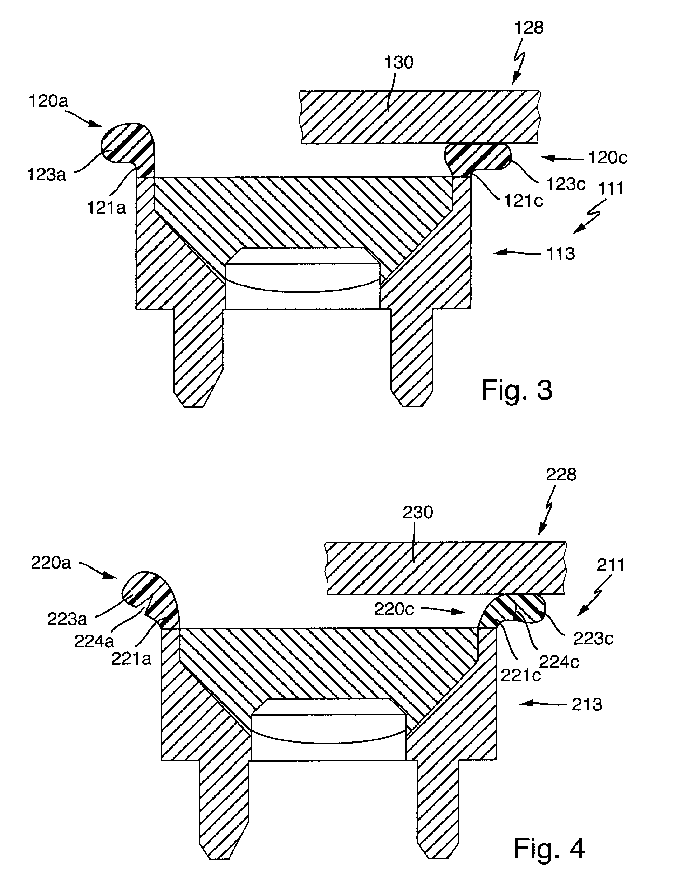

In einer Variation eines Bedienelements 111 gemäß der Fig. 3 ist links eine Rippe 120a dargestellt, deren Querschnitt in etwa winklig bzw. rechtwinklig abgewinkelt ausgebildet ist. Ein abgerundeter abstehender Abschnitt 123a geht ab von einem Basisbereich 121 a, der sich vom Bedienelementgehäuse 113 nach oben erstreckt.

Rechts in Fig. 3 ist der eingebaute Zustand dargestellt, wenn also das Bedienelement 111 gegen die Unterseite einer Bedienfläche 130 gedrückt ist, also ähnlich wie in Fig. 2. Hier ist zu ersehen, dass dann der abstehende Abschnitt 123c nach unten gedrückt wird und somit im Wesentlichen eine Biegeverformung der Rippe 120c erfolgt. Ab einem bestimmten Weg des Zusammendrückens kann zumindest der Basisbereich 121 c nur komprimiert werden, wodurch die Federkraft bzw. der Widerstand der Rippe 120c gegen Zusammendrücken deutlich ansteigt.

In der Fig. 4 ist ein weiteres Bedienelement 211 dargestellt. Eine links im entspannten Zustand dargestellte Rippe 220a weist einen Basisbereich 221a auf und daran anschließend einen abstehenden Abschnitt 223a. Dazwischen ist ein Einschnitt 224 vorgesehen, der erkennbar einer leichteren Biegbarkeit des abstehenden Abschnitts 223a nach unten dient. Dies ist in Fig. 4 aus der rechten Seite zu erkennen, wenn das Bedienelement 211 an die Unterseite einer Bedienfläche 230 angedrückt ist. Dann wird der abstehende Abschnitt 223c so weit nach unten gebogen, dass er voll an dem Basisbereich 221 c anliegt und somit der Einschnitt 224 quasi geschlossen ist. Ab hier wird, wie zuvor ähnlich für die Fig. 3 beschrieben, der Widerstand der Rippe 220c gegen weiteres Zusammendrücken stark ansteigen.

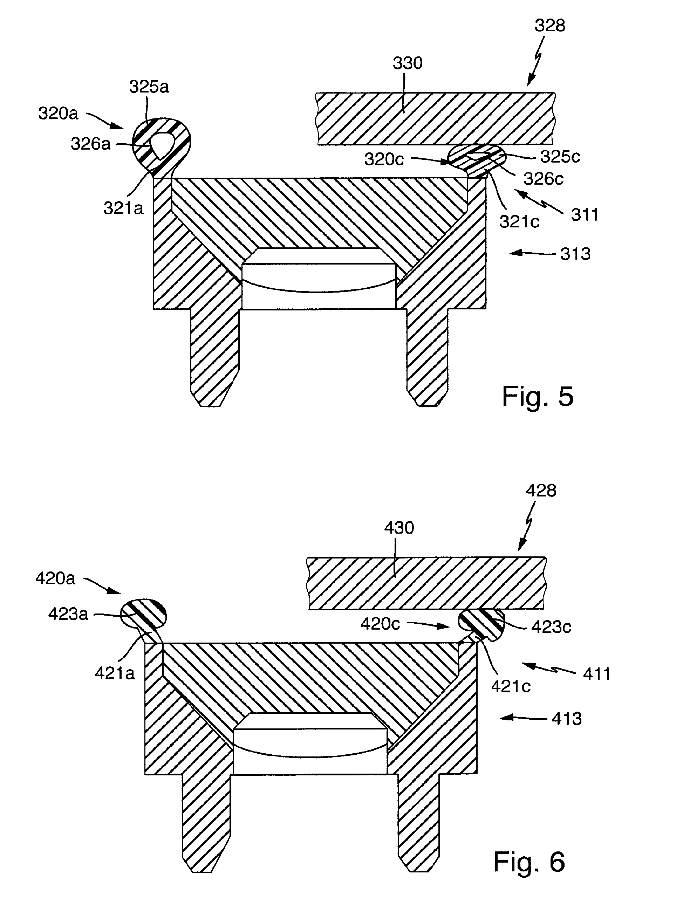

In der Fig. 5 ist ein weiteres Bedienelement 311 dargestellt, welches im linken Bereich oben auf dem Bedienelementgehäuse 313 eine Rippe 320a aufweist. Diese Rippe 320a weist über einem Basisbereich 321a einen Ringbereich 325a mit Hohlraum 326a auf. Durch diesen Hohlraum 326 kann, wie rechts in der Fig. 5 deutlich zu erkennen ist, eine Rippe 320 leicht zusammengedrückt werden bei Andrücken an die Unterseite einer Bedienfläche 330. Auch hier kann das Zusammendrücken bzw. Verformen der Rippe 320 so lange relativ leicht erfolgen, bis der Hohlraum 326 sozusagen verschwunden ist. Ab diesem Punkt kann die Rippe 320 nur noch zusammengequetscht werden mit elastischer Kompression des Materials.

Eine nochmals weitere Ausgestaltung ist in der Fig. 6 dargestellt. Dort weist ein Bedienelement 411 im linken Bereich eine Rippe 420a auf mit einem Basisbereich 421, der etwas über das Bedienelementgehäuse 413 und leicht nach außen steht. Der Basisbereich 421 a trägt einen im Verhältnis dazu deutlich größeren nach außen abstehenden Abschnitt 423a, so dass der Basisbereich 421 a im Vergleich dazu dünn ist.

Rechts aus der Fig. 6 ist zu erkennen, dass das Andrücken an die Unterseite einer Bedienfläche 430 den Basisbereich 421 abknickt, während der abstehende Abschnitt 423c an seiner Oberseite nur wenig zusammengedrückt bzw. flachgedrückt wird. Hier entsteht die leichte Formveränderbarkeit der Rippen 420 vor allem durch die Ausgestaltung des Basisbereichs 421. Der Vorteil bei dieser Ausgestaltung der Erfindung liegt darin, dass über einen größeren Bereich des Andrückens der Rippen 420 an die Unterseite der Bedienfläche 430 die sich bildende Kontaktfläche oben an der Rippe 420 bzw. an dem abstehenden Abschnitt 423 in etwa gleichbleibt. Dies wird dadurch erreicht, dass im Wesentlichen nur der Basisbereich 421 abgebogen bzw. nach unten gebogen wird.

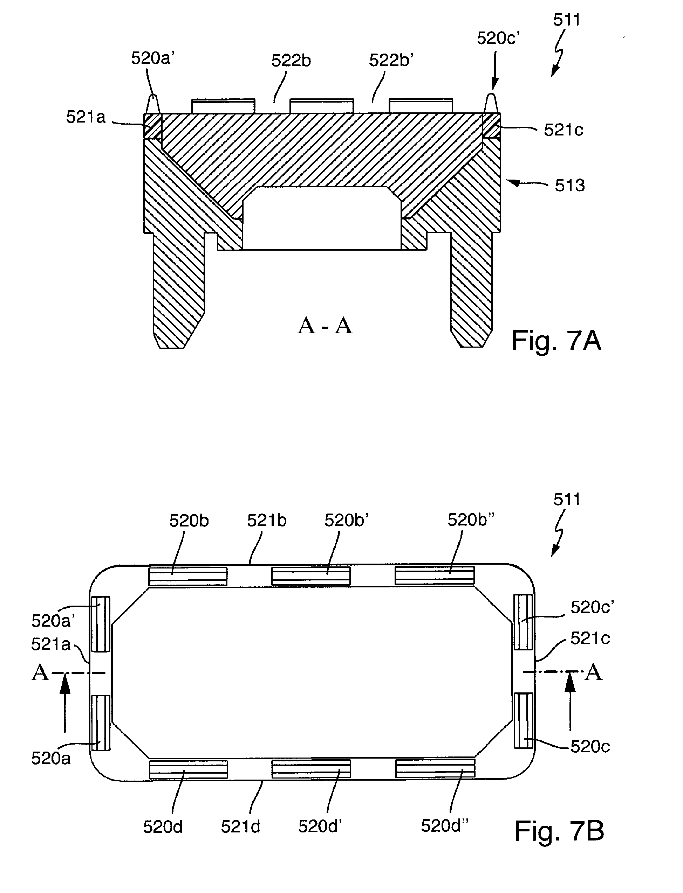

In den Fig. 7A im Seitenschnitt und 7B in der Draufsicht dazu ist ein weiteres erfindungsgemäßes Bedienelement 511 gemäß dem eingangs genannten ersten grundlegenden Aspekt der Erfindung dargestellt, das im Wesentlichen dem vorherigen entspricht und nur bezüglich seiner Abweichungen näher erläutert wird. Das Bedienelement 511 weist ein Bedienelementgehäuse 513 auf mit Rippen auf der Oberseite oder an einem Außenrand des Bedienelementgehäuses bzw. Rippenabschnitten 520a und 520a' auf der linken Seite, 520b, 520b' und 520b" auf der hinteren und Rippenabschnitten 520d, 520d' und 520d" an der vorderen Längsseite sowie Rippenabschnitten 520c und 520' an der rechten bzw. rechten kurzen Längsseite. Die Rippen weisen gemäß der Fig. 7A links eine Rippenbasis 521 a und rechts eine Rippenbasis 521 c auf, welche hier im Schnitt dargestellt ist. Somit sind diese Rippen nicht nur direkt oben auf das Bedienelementgehäuse 513 oder einen jeweiligen Kunststoff aufgespritzt oder eingesetzt, sondern zur erhöhten Stabilität sind die Rippenbasen 521a bis 521d in einen entsprechenden winkligen Ausschnitt eingespritzt. Von ihnen aus erstrecken sich die einzelnen Rippenabschnitte 520 nach oben.

Es ist deutlich sowohl von der Seite als auch von oben zu erkennen, dass im Vergleich zu beispielsweise der Fig. 1 keine über den wesentlichen Teil einer Länge einer Seite des Bedienelementgehäuses 513 verlaufende Rippe vorgesehen ist. Hier werden durch die in Fig. 7A erkennbaren Unterbrechungen 522b und 522b' die einzelnen Rippenabschnitte 520b, 520b' und 520b" geschaffen. Aus dem Querschnitt ist zu erkennen, dass die Rippenabschnitte 520 nach oben bzw. von der Oberseite weg verjüngt sind und am Ende einen abgerundeten Bereich aufweisen. Dadurch ergibt sich einerseits zwar eine relativ schmale Anlagefläche an der Unterseite einer Bedieneinrichtung bzw. deren Bedienfläche beispielsweise gemäß Fig. 2. Für die Funktion als kapazitives Sensorelement bzw. kapazitiver Berührungssensor reicht dies jedoch. Aufgrund des Verhältnisses der Gesamtlänge der Unterbrechungen 522b und 522b' einerseits und der Rippenabschnitte 520b, 520b' und 520b" andererseits ergibt sich aber eine Reduzierung der Andrückkraft. Hier ist eine Unterbrechung 522 knapp halb so lang wie ein Rippenabschnitt 520, so dass die notwendige Andrückkraft um ein Viertel bis ein Drittel gesenkt wird.

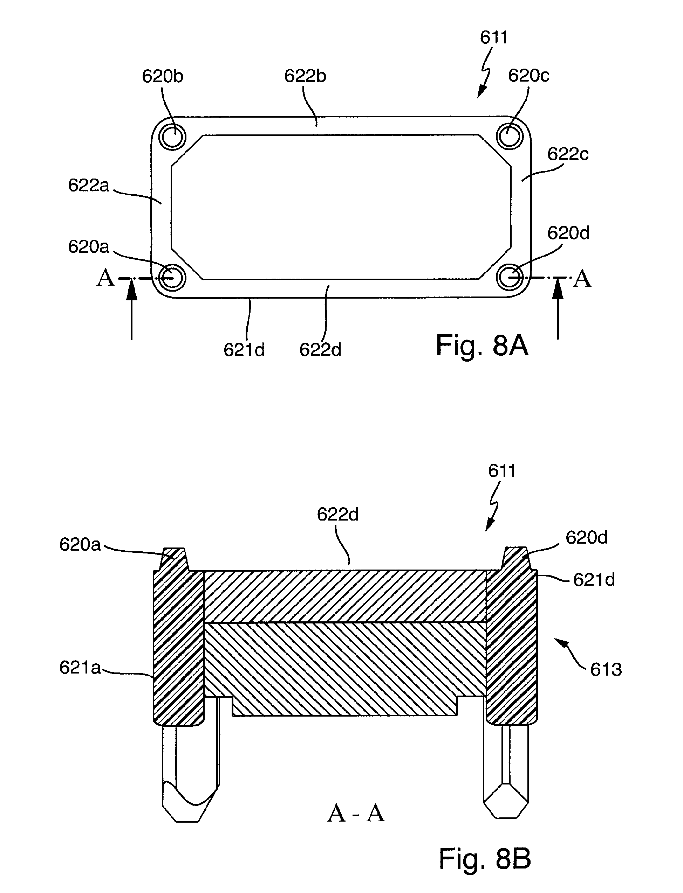

In den Fig. 8A in der Draufsicht und 8B im Schnitt gemäß A-A ist ein Ausführungsbeispiel einer ebenfalls eingangs beschriebenen Ausgestaltung eines Bedienelements 611 dargestellt, bei dem Rippenabschnitte 620a bis 620d quasi derart stark verkürzt sind, dass sie sozusagen so lang wie breit sind und nur noch eine Art Pfosten bilden. Diese pfostenartigen Rippenabschnitte 620a bis 620d sind hier in Eckbereichen auf der Oberseite des Bedienelementgehäuses 613 vorgesehen bzw. sind an Rippenbasen 621 a und 621 d gemäß Fig. 8B oben angespritzt, wobei sich hier diese Rippenbasen bis an die Unterseite erstrecken und insbesondere einer elektrischen Kontaktierung nach unten dienen ähnlich den Kontaktierungen 27 bzw. dem Kontaktierbereich 27' der Fig. 1. Die pfostenartigen Rippenabschnitte 620a bis 620d könnten auch jeweils in etwa in der Mitte einer Längsseite des Bedienelements 611 sitzen. Des Weiteren könnten auch eventuell mehrere davon vorgesehen sein. Jedenfalls ist hier zu erkennen, dass die runden und kegelstumpfartigen bzw. rotationssymmetrischen Rippenabschnitte 620a bis 620d im Vergleich zu den Fig. 7A und 7B extrem verkürzte Rippenabschnitte mit sehr langen Unterbrechungen 622a bis 622d bilden, was gleichzeitig eine stark verringerte Andrückkraft bewirkt. Bei Versuchen hat es sich jedoch herausgestellt, dass dies für die Funktion als kapazitives Sensorelement bzw. als kapazitiver Berührungsschalter ausreicht. Durch die Verjüngung der pfostenartigen Rippenabschnitte 620a bis 620d kann einerseits eine nochmalige leichte Reduzierung der Andrückkraft erreicht werden und andererseits eine leichtere Herstellung erreicht werden.

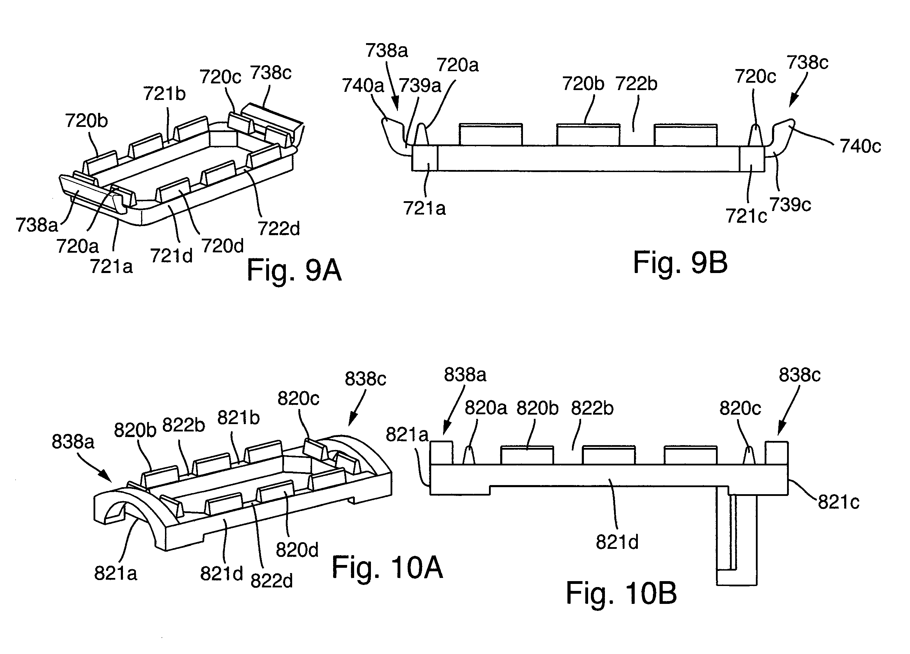

In den Fig. 9A und 9B ist, wie auch in den weiteren Figuren, nicht mehr ein gesamtes Bedienelement dargestellt, sondern sozusagen nur noch ähnlich der Fig. 7A eine umlaufende Rippenbasis 721 mit an der Oberseite vorgesehenen Rippen bzw. Rippenabschnitten 720. Diese Rippenbasis 721 kann wie zuvor beschrieben an einem Bedienelementgehäuse angeformt sein, das hier der Einfachheit halber nicht gänzlich dargestellt ist.

Zum einen ist bei den Fig. 9A in der schrägen Draufsicht und 9B in der Seitenansicht zu erkennen, dass entsprechend Fig. 7A und 7B einzelne Rippenabschnitte 720 vorgesehen sind, die im Einzelnen nicht benannt werden, da sie ja insofern den genannten Fig. 7A und 7B entsprechen. Im Bereich der Rippenbasen 721a und 721 c sind jedoch zusätzlich zu den Rippenabschnitten 720 noch zusätzliche Rippen 738a und 738c vorgesehen. Diese weisen, quasi ähnlich wie bei den Ausführungsbeispielen der Fig. 3 und 4, im Querschnitt eine Biegung auf, aber eben genau andersherum als bei den vorgenannten Fig. 3 und 4. Von den Rippenbasen 721 aus verläuft zuerst ein Rippenansatz 739a bzw. 739c zur Seite weg bzw. nach außen. Dann ist die Rippe jeweils nach oben gebogen und mündet in einen Endbereich 740a bzw. 740c. Dieser steht dann im Wesentlichen nach oben bzw. weist einen Winkel zu einer dann von oben angedrückten Bedienfläche bzw. einer Oberseite eines gesamten Bedienelementkörpers von etwa 75° bis 90° auf. Durch die leichte Verbreiterung der Rippen zum freien Ende bzw. zu dem Endabschnitt 740a bzw. 740c hin wird eine breitere Anlage an der Unterseite der Bedienfläche bzw. eine etwas vergrößerte Anlagefläche geschaffen. Ähnlich wie bei dem Ausführungsbeispiel der Fig. 3 und 4 wird hier die Elastizität bzw. leichte Biegbarkeit nach unten vor allem durch die Ausgestaltung bzw. Formgebung erreicht, nämlich durch die Abwinkelung.

Bei diesem Ausführungsbeispiel ist also zu ersehen, dass quasi beide Arten von Rippen, einerseits mit Unterbrechungen und andererseits mit einer gewinkelt abstehenden Ausbildung, gemeinsam an einem Bedienelement vorgesehen sein können. Es versteht sich aber von selbst, dass vorteilhaft auch nur entweder die beiden abgewinkelten Rippen 738a und 738c vorgesehen sind, also keinerlei Rippenabschnitte 720 mit Unterbrechungen dazwischen, oder diese noch mit abgewinkelten Rippen 738 entlang der langen Längsseiten eines Bedienelementgehäuses.

Eine nochmals weitere Ausgestaltung von Rippen bzw. Rippenabschnitten für ein Bedienelement ist in den Fig. 10A in der Schrägansicht und 10B in der Seitenansicht dargestellt. Auch diese Ausgestaltung geht, ähnlich wie diejenige der Fig. 9A und 9B, aus von der Fig. 7A mit den Rippenbasen 821a bis 821d und den darauf sitzenden Rippenabschnitten 820. An den Rippenbasen 821a und 821c sind hier jedoch, anders als in Fig. 9A und 9B, keine im Längsquerschnitt abgebogenen oder abgewinkelten Rippen vorgesehen, sondern brückenartig im Längsverlauf gewölbte Rippen 838a und 838c. Sie verlaufen über die gesamte Breite der kurzen Längsseiten bzw. der Rippenbasen 821 a und 821 c. Sie sind in etwa gleichmäßig gewölbt auf einer Oberseite und stehen etwas über die Oberkanten der Rippenabschnitte 820 über. Bei einer Länge der Bedienelementgehäuse von etwa 10 mm können die Rippenabschnitte etwa 0,6 mm hoch sein, während sich die Rippen 838a und 838c, ähnlich wie die Rippen 738a und 738c, etwa 1 mm nach oben erstrecken, die jeweiligen Rippenabschnitte also um etwa 0,4 mm überragen.

Aus der Fig. 10A wird auch deutlich, dass sich durch die im Längsverlauf nach oben gebogene Form der Rippen 838a und 838c, beginnend von einem Ansatz an den Rippenbasen 821 a bzw. 821 c, eine sehr elastische Ausgestaltung ergibt bzw. eine geringe Andrückkraft an eine Unterseite einer Bedienfläche zu erwarten ist. Bei einer solchen Anlage wird die Rippe 838 wohl nicht mit ihrer gesamten Länge an der Unterseite der Bedienfläche anliegen, aber wahrscheinlich mit etwa 30% bis 60%. Dies hat sich in Versuchen als ausreichend erwiesen für die Funktion als kapazitives Sensorelement eines Berührungsschalters.

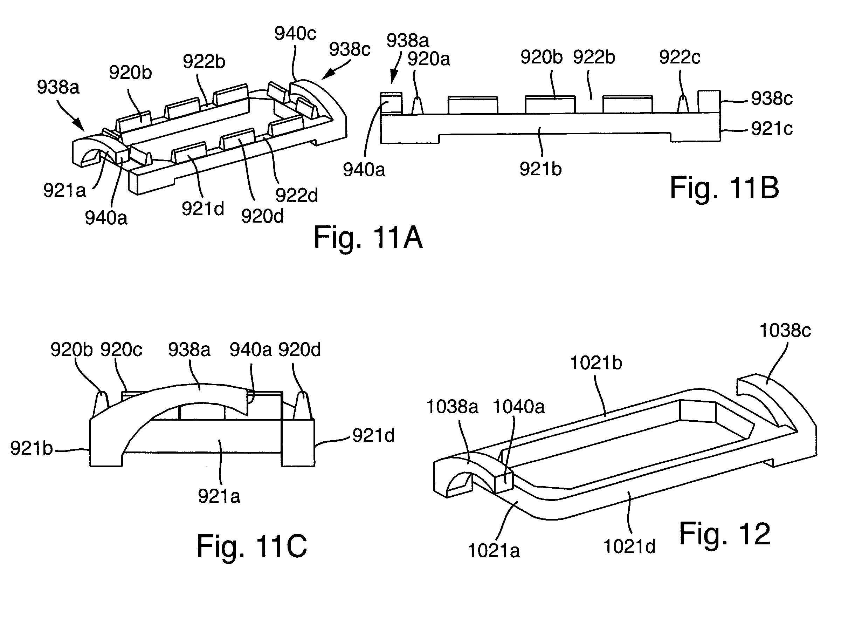

Eine Abwandlung der Ausgestaltung der Fig. 10A und 10B ist in den Fig. 11A bis 11C dargestellt. Hier sind auch Rippenbasen 921a bis 921 d dargestellt, die Rippenabschnitte 920 mit Unterbrechungen dazwischen tragen. An den Rippenbasen 921a und 921c sind im Längsverlauf Rippen 938a und 938c vorgesehen. Diese sind allerdings anders als bei der Ausgestaltung der Fig. 10A und 10B nicht durchgehend bzw. an beiden Enden mit einer Rippenbasis 921 verbunden, sondern nur an einem Ende. Das andere Ende der Rippen 938 ist als freies Ende 940a bzw. 940c eben frei. Dadurch kann erkennbar die Flexibilität der Rippen 938 nochmals deutlich gesteigert werden bzw. eine daraus resultierende Andrückkraft an die Unterseite einer Bedienfläche wird sehr gering, da es absehbar sehr leicht ist, die Rippe 938 etwas nach unten zu biegen. Die Fläche bzw. Größe des an der Bedienfläche anliegenden Bereichs dürfte wahrscheinlich ähnlich sein wie bei der Ausführung der Fig. 10A und 10B. Ebenso stehen die Rippen 938 an ihrem höchsten Punkt ähnlich hoch wie bei dem Ausführungsbeispiel der Fig. 10A und 10B.

In der Fig. 12 ist eine nochmals weitere Ausgestaltung der Erfindung dargestellt, welche von dem Ausführungsbeispiel der Fig. 11A bis 11C ausgeht bzw. dieselben Rippenbasen 1021 a bis 1021d sowie Rippen 1038a und 1038b aufweist, identisch wie in dem vorgenannten Ausführungsbeispiel. Allerdings sind hier auf den Oberseiten der Rippenbasen 1021 a bis 1021d keine Rippenabschnitte vorgesehen, so dass das kapazitive Sensorelement nur mit den Oberseiten der Rippen 1038a und 1038b an der Unterseite einer Bedienfläche anliegt für die Wirkung eines kapazitiven Berührungsschalters. Auch dies hat sich aber als ausreichend herausgestellt. Durch das Weglassen der Rippenabschnitte wird als möglicher Federweg die volle Höhe des Überstands der Rippen 1038 über die Oberseite der Rippenbasen 1021 erreicht. Dadurch dass die Rippen 1038 an Überständen bzw. Vorsprüngen angeordnet sind, die von den Rippenbasen 1021 a und 1021 c abstehen, können die Rippen selbst an ihrem Ansatz an diesen Vorsprüngen noch nach unten gedrückt werden bei ausreichender Andrückkraft, so dass tatsächlich die Oberseite der Rippenbasen 1021 an die Unterseite einer Bedienfläche angedrückt werden kann, falls dies notwendig sein sollte.

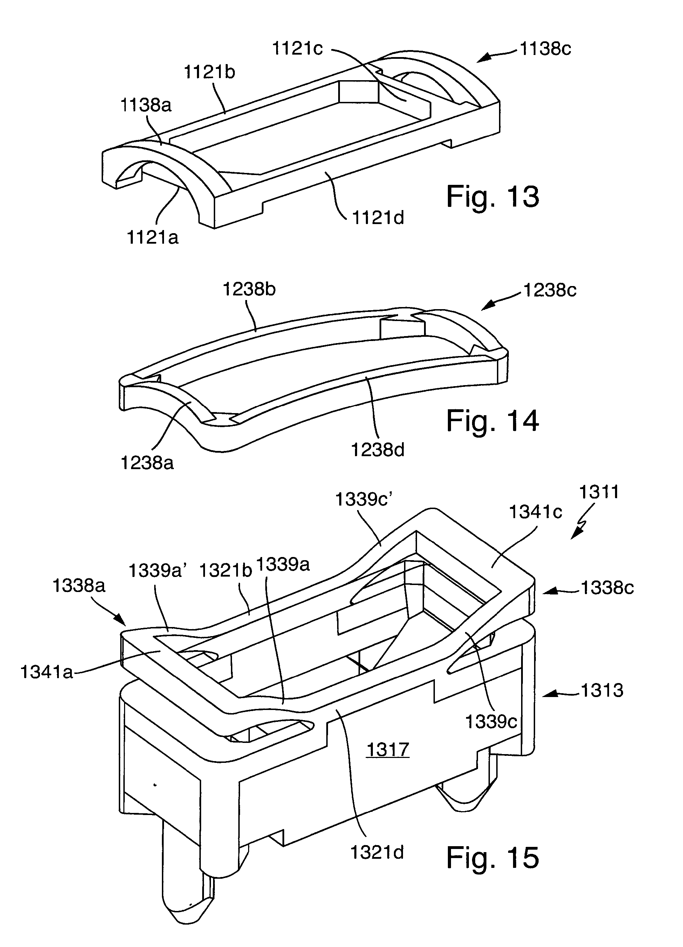

Eine nochmals weitere Ausgestaltung ausgehend von der Fig. 12 ist in Fig. 13 dargestellt, die im Prinzip der Ausgestaltung der Fig. 10A und 10B entspricht nur ohne Rippenabschnitte auf den Oberseiten von Rippenbasen 1121a bis 1121d. Hier sind ebenfalls an den kurzen Rippenbasen 1121 a und 1121 c bzw. an davon nochmals nach vorne stehenden Vorsprüngen bogenartige Rippen 1138a und 1138c vorgesehen. Diese sind an sich genauso ausgebildet wie in den Fig. 10A und 10B, auf welche verwiesen wird. Durch sie können auch dieselben Vorteile erreicht werden wie dort genannt.

In der Fig. 14 ist eine nochmals weitere Ausgestaltung dargestellt, bei der sozusagen alle Rippenbasen als nach oben stehende und gewölbte Rippen 1238a bis 1238d ausgebildet sind. Lediglich in den Eckbereichen, in denen die Rippen 1238a bis 1238d miteinander verbunden sind, sind sie auch mit einem Bedienelementgehäuse bzw. einem Mantelkörper verbunden, insbesondere daran angespritzt. Mit dieser Ausgestaltung wird quasi von derjenigen der Fig. 13 ausgehend die Andrückkraft etwas erhöht, da nun eigentlich alle vier bogenförmigen Rippen 1238a bis 1238d an der Unterseite einer Bedienfläche anliegen können und sollen. Da durch die bogenförmige Ausgestaltung aber ohnehin eine sehr geringe Andrückkraft vorliegt dürfte dies nicht stören. Des Weiteren wird die Anlagefläche deutlich vergrößert bzw. mindestens verdoppelt.

Etwas komplexer ist das Ausführungsbeispiel der Fig. 15 mit einem Bedienelement 1311 samt Bedienelementgehäuse 1313, bei dem an der Oberseite eine komplexe Struktur aus entsprechend elastischem und elektrisch leitfähigem Kunststoff vorgesehen bzw. angespritzt ist. Einerseits ist zwar, ähnlich wie zuvor, an die Oberseite eines Lichtleiters 1317 solcher Kunststoff rundumlaufend bzw. rahmenartig angespritzt mit zwei Rippenbasen 1321b und 1321d entlang der langen Längsseiten des Bedienelements 1311. Es sind auch im Längsverlauf nach oben stehende Rippen 1338a und 1338c vorgesehen, wobei diese jeweils nicht von den Eckbereichen zwischen den Rippenbasen abgehen, sondern eher zur Mitte hin mit den Rippenbasen 1321b und 1321d verbunden sind. Rippenansätze 1339a und 1339a' bzw. 1339c und 1339c' gehen von den Rippenbasen 1321 b und 1321 d ab mit Biegung schräg nach oben mit Richtung zu den kurzen Längsseiten des Bedienelementgehäuses 1313. Oberhalb der kurzen Längsseiten gehen sie in einen jeweils quer verlaufenden Querbereich 1341a und 1341c über, und die Oberseiten dieser Querbereiche 1341 a und 1341 c liegt dann an der Unterseite einer Bedienfläche an. Wie leicht zu erkennen ist, wird die durch die Formgebung erreichte Federwirkung durch eine Art Scharnierfunktion an den Ansätzen 1339 erreicht, die auch erkennbar sehr dünn ausgebildet sind. Des Weiteren können auch die Längsbereiche zwischen den Querbereichen 1341 und den Ansatzbereichen 1339 nach unten gebogen werden für eine Flexibilität bzw. federnde Ausgestaltung.

Mit dieser Ausführung kann eine ebenfalls sehr geringe Andrückkraft erreicht werden bei doch recht großer Andrückfläche, nämlich derjenigen der im Wesentlichen vollen Oberseiten der Querbereiche 1341. Zur nochmaligen weiteren Reduzierung einer notwendigen Andrückkraft könnten die Querbereiche 1341 noch entsprechend der Ausgestaltung der Fig. 10A und 10B nach oben gebogen sein.

## Patentansprüche

1. Bedienelement mit einem Bedienelementgehäuse, in dessen oberem Bereich bzw. auf oder an dessen Oberseite mindestens eine zumindest teilweise entlang laufende, abstehende Rippe aus elastischem Material angeordnet ist, **dadurch gekennzeichnet, dass** im Längsverlauf dieser Rippe eine Unterbrechung in diesem Längsverlauf vorgesehen ist zur Unterteilung der Rippe in mindestens zwei abstehende Rippenabschnitte.

2. Bedienelement nach Anspruch 1, **dadurch gekennzeichnet, dass** das Bedienelementgehäuse in der Draufsicht eckig ausgebildet ist, vorzugsweise rechteckig, mit Rippen entlang jeder Seite, wobei entlang jeder Seite die Rippe in mindestens zwei Rippenabschnitte unterteilt ist durch die Unterbrechungen.

3. Bedienelement nach Anspruch 2, **dadurch gekennzeichnet, dass** die Summe der Längen der Unterbrechungen entlang einer Seite kleiner ist als die Summe der Längen der einzelnen Rippenabschnitte, vorzugsweise 20% bis 60% von der Summe deren Länge beträgt.

4. Bedienelement nach Anspruch 1 oder 2, **dadurch gekennzeichnet, dass** die Summe der Längen der Unterbrechungen in der Rippe größer ist als die Summe der Längen der Rippenabschnitte selbst, wobei vorzugsweise die Summe der Längen der Unterbrechungen 5mal bis 20mal so groß ist wie die Summe der Längen der Rippenabschnitte.

5. Bedienelement nach Anspruch 4, **dadurch gekennzeichnet, dass** das Bedienelementgehäuse in der Draufsicht mehreckig ist, vorzugsweise rechteckig, wobei Rippenabschnitte nur in Eckbereichen des Bedienelementgehäuses vorgesehen sind, insbesondere in jedem Eckbereich genau ein Rippenabschnitt mit einer Länge, die in etwa seiner Breite entspricht.

6. Bedienelement nach einem der vorhergehenden Ansprüche, **dadurch gekennzeichnet, dass** die Breite der Rippen zwischen 50% und 150% der Höhe der Rippen beträgt, vorzugsweise etwa gleich groß ist, insbesondere die Breite der Rippen am Ansatz am Bedienelementgehäuse bzw. dessen Oberseite.

7. Bedienelement mit einem Bedienelementgehäuse, in dessen oberem Bereich bzw. auf dessen Oberseite eine zumindest teilweise entlang laufende, abstehende Rippe aus elastischem Material angeordnet ist, **dadurch gekennzeichnet, dass** die Rippe bzw. ihr Querschnitt für eine Formelastizität ausgebildet ist, insbesondere durch einen elastisch abstehenden Abschnitt mit einer Erstreckungsrichtung weg von der sonstigen Rippe im Wesentlichen schräg zu einer Ebene der Oberseite des Bedienelements.

8. Bedienelement nach Anspruch 7, **dadurch gekennzeichnet, dass** der abstehende Abschnitt den wesentlichen Bereich der Rippe bildet, vorzugsweise oberhalb des Bedienelementgehäuses.

9. Bedieneinrichtung nach Anspruch 7 oder 8, **dadurch gekennzeichnet, dass** der abstehende Abschnitt von einer Oberseite des Bedienelementgehäuses nach außen wegsteht, wobei insbesondere der abstehende Abschnitt das Bedienelementgehäuse seitlich nach außen überragt.

10. Bedienelement nach einem der Ansprüche 7 bis 9, **dadurch gekennzeichnet, dass** der abstehende Abschnitt einen Winkel zwischen 30° und 60° zur Ebene der Oberseite des Bedienelements aufweist, vorzugsweise 40° und 50°.

11. Bedienelement nach einem der Ansprüche 7 bis 10, **dadurch gekennzeichnet, dass** die Rippe bzw. ihr Querschnitt massiv ist ohne Hohlräume, insbesondere in einem Bereich über dem Bedienelementgehäuse.

12. Bedienelement nach einem der Ansprüche 7 bis 10, **dadurch gekennzeichnet, dass** die Rippe bzw. ihr Querschnitt eine hinterschnittene Öffnung aufweist oder hohl ist, insbesondere nach Art eines Scharniers.

13. Bedienelement nach einem der Ansprüche 7 bis 12, **dadurch gekennzeichnet, dass** die Rippe länglich ist und im Längsquerschnitt gesehen konvex gebogen ist weg von der Oberseite des Bedienelementgehäuses, wobei vorzugsweise die Endrichtung der Biegung an einer freien Kante der Rippe in einem Winkel von 60° bis 90° zur Oberseite steht.

14. Bedienelement nach Anspruch 13, **dadurch gekennzeichnet, dass** nur an zwei von vier Längsseiten des Bedienelementgehäuses jeweils eine abstehende Rippe mit Biegung im Längsquerschnitt vorgesehen ist, vorzugsweise an gegenüberliegenden Längsseiten und insbesondere an gegenüberliegenden kürzeren Längsseiten.

15. Bedienelement nach einem der Ansprüche 7 bis 12, **dadurch gekennzeichnet, dass** die Rippe länglich ist und in ihrem Längsverlauf gebogen ist beginnend von einem Ansatz an dem Bedienelementgehäuse zuerst nach oben über die Oberseite des Bedienelementgehäuses hinaus mit flacher werdendem Biegungswinkel, wobei vorzugsweise die Rippe in ihrem Längsverlauf nach Überschreiten eines Höhepunkts wieder nach unten gebogen ist und vorzugsweise am anderen Ende mit dem Bedienelementgehäuse verbunden ist, insbesondere an einer Ecke des Bedienelementgehäuses, oder das andere Ende frei und ohne Befestigung ist.

16. Bedienelement nach Anspruch 15, **dadurch gekennzeichnet, dass** der Verlauf einer Rippe mit Biegung in ihrem Längsverlauf in Draufsicht auf das Bedienelementgehäuse abweichend von einer Geraden gebogen bzw. U-förmig ist, wobei vorzugsweise eine Rippe an beiden Enden mit dem Bedienelementgehäuse verbunden bzw. daran befestigt ist und insbesondere innerhalb des Umrisses des Bedienelementgehäuses in der Draufsicht auf die Oberseite verläuft.

17. Bedienelement nach einem der vorhergehenden Ansprüche, **dadurch gekennzeichnet, dass** das Bedienelementgehäuse im Wesentlichen rechteckig ausgebildet ist und an mindestens zwei der Seiten eine Rippe verläuft, wobei insbesondere an allen vier Seiten des Bedienelementgehäuses je eine Rippe angeordnet ist.

18. Bedienelement nach Anspruch 17, **dadurch gekennzeichnet, dass** in Eckbereichen des Bedienelementgehäuses kein abstehender Abschnitt vorgesehen ist, wobei vorzugsweise die Rippe über die Eckbereiche verläuft zur Verbindung von abstehenden Abschnitten von unterschiedlichen Seiten des Bedienelementgehäuses untereinander ohne abstehende Abschnitte an den Eckbereichen.

19. Bedienelement nach einem der vorhergehenden Ansprüche, **dadurch gekennzeichnet, dass** die Höhe eines abstehenden Abschnitts 0,5 mm bis 3 mm beträgt, vorzugsweise 0,8 mm bis 1,5 mm.

20. Bedienelement nach einem der vorhergehenden Ansprüche, **dadurch gekennzeichnet, dass** das elastische Material TPE ist, insbesondere elektrisch leitfähiges TPE, wobei vorzugsweise Zusätze für die elektrische Leitfähigkeit aus der folgenden Gruppe gewählt sind: Ruß, Graphit, Metallpulver, Carbon-Nanotubes.
